# EUROPEAN PATENT APPLICATION

(11) **EP 4 722 807 A1**
(43) Date of publication of application: **08.04.2026**
(21) Application number: 24204137.4
(22) Date of filing: 02.10.2024
(51) Int. Cl.: G03F 7/00

(54) **LITHOGRAPHY PROJECTION METHOD AND LITHOGRAPHIC APPARATUS**

(71) Applicant: ASML Netherlands B.V., 5500 AH Veldhoven (NL)
(72) Inventor: VROMEN, Joost, Anton, Frits, 5500 AH Veldhoven (NL); SLACHTER, Abraham, 5500 AH Veldhoven (NL); GANG, Tian, 5500 AH Veldhoven (NL); BOOGAARTS, Martinus, Godefridus, Helena, 5500 AH Veldhoven (NL); NISHCHENKO, Nataliya, Ivanivna, 5500 AH Veldhoven (NL)
(74) Representative: ASML Netherlands B.V.

(57) **Abstract**

The disclosure provides a lithography projection method, comprising:
providing a radiation beam,
imparting the radiation beam with a pattern of a patterning device in its cross-section to form a patterned radiation beam,
projecting the patterned radiation beam on multiple exposure fields of a substrate,

wherein imparting the radiation beam with the pattern of the patterning device comprises moving the patterning device with a scanning movement in a scanning direction with respect to an exposure slit mainly extending in a slit direction perpendicular to the scanning direction,
wherein the lithography projection method further comprises:
splitting in the slit direction at least one of the multiple exposure fields in two or more partial exposure fields, and
projecting the patterned radiation beam on the two or more partial exposure fields in two or more separate scanning movements of the patterning device in the scanning direction.

## Description

### FIELD

The present invention relates to a lithography projection method and a lithographic apparatus.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask or reticle) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 2-20 nm, for example 6.7 nm or 13.5 nm, may be used to form smaller features on a substrate than a lithographic apparatus which uses, for example, radiation with a wavelength of 193 nm.

In a lithography projection method, a radiation beam is imparted with a pattern of a patterning device in its cross-section to form a patterned radiation beam. This patterned radiation beam is projected on multiple exposure fields of a substrate.

The lithographic apparatus may be a scanning type lithographic apparatus, wherein imparting the radiation beam with the pattern of the patterning device comprises moving the patterning device with a scanning movement in a scanning direction with respect to an exposure slit mainly extending in a slit direction perpendicular to the scanning direction. The exposure slit defines the radiation beam that reaches the substrate.

In practice, the substrate on which the patterned radiation beam is projected may be deformed, for example due to clamping of the substrate on the substrate support. This deformation, for example in-plane deformation, may lead to overlay and/or focus errors. To avoid the overlay and/or focus errors, corrections may be applied. These overlay and/or focus corrections may for example include correction of the positioning of the patterning device and/or correction of the position of reflective surfaces in the projection system of the lithographic apparatus to adjust a position of an aerial image of the patterned radiation beam projected on the exposure field of the substrate.

During the scanning movement in scanning direction, corrections can be made based on the measured deformation of the substrate. Due to the shape of the exposure slit which mainly extends in a slit direction perpendicular to the scanning direction, corrections in the slit direction may be more challenging than corrections in the scanning direction. In practice, some exposure fields may have deformations for which no suitable correction is available.

### SUMMARY

It is an object of the present disclosure to provide a lithography projection method that enables improved overlay and/or focus corrections in the lithographic process, in particular overlay and/or focus corrections in the slit direction of the exposure slit. It is another object of the present disclosure to provide a lithographic apparatus that enables such improved overlay and/or focus correction.

According to an aspect of the disclosure there is provided a lithography projection method, comprising:
providing a radiation beam,
imparting the radiation beam with a pattern of a patterning device in its cross-section to form a patterned radiation beam,
projecting the patterned radiation beam on multiple exposure fields of a substrate,
   wherein imparting the radiation beam with the pattern of the patterning device comprises moving the patterning device with a scanning movement in a scanning direction with respect to an exposure slit mainly extending in a slit direction perpendicular to the scanning direction,
   wherein the lithography projection method further comprises:
splitting in the slit direction at least one of the multiple exposure fields in two or more partial exposure fields, and
projecting the patterned radiation beam on the two or more partial exposure fields in two or more separate scanning movements of the patterning device in the scanning direction.

According to an aspect of the disclosure there is provided lithographic apparatus, comprising:
a substrate table constructed to hold a substrate;
a projection system configured to project a radiation beam through an exposure slit area onto multiple exposure fields of the substrate; and
a patterning device configured to impart the radiation beam with a pattern in its cross-section to form a patterned radiation beam, wherein the patterning device is arranged to be moved with a scanning movement in a scanning direction with respect to the exposure slit, the exposure slit mainly extending in a slit direction perpendicular to the scanning direction; and
wherein the lithographic apparatus is arranged to:
split in the slit direction at least one of the multiple exposure fields in two or more partial exposure fields, and
project the patterned radiation beam on the two or more partial exposure fields in two or more separate scanning movements of the patterning device in the scanning direction.

### BRIEF DESCRIPTION OF THE DRAWINGS

Embodiments of the invention will now be described, by way of example only, with reference to the accompanying schematic drawings, in which:
- Figure 1 depicts a lithographic system comprising a lithographic apparatus and a radiation source;
- Figure 2 schematically depicts a cross-section of a patterned radiation beam in a scanning movement with respect to an exposure field;
- Figure 3 schematically depicts an overlay error related parameter in slit direction and an overlay correction to at least partially correct the overlay error related parameter;
- Figures 4A and 4B schematically depict an adapted patterned radiation beam that is exposed in two separate scanning movements to partial exposure fields;
- Figure 5 schematically depicts an overlay error related parameter in slit direction and two overlay corrections values to at least partially correct the overlay error related parameter during the separate scanning movements of Figure 4A and 4B; and
- Figure 6 schematically depicts a radiation intensity received by the partial exposure fields during the two scanning movements of Figs. 4A and 4B.

### DETAILED DESCRIPTION

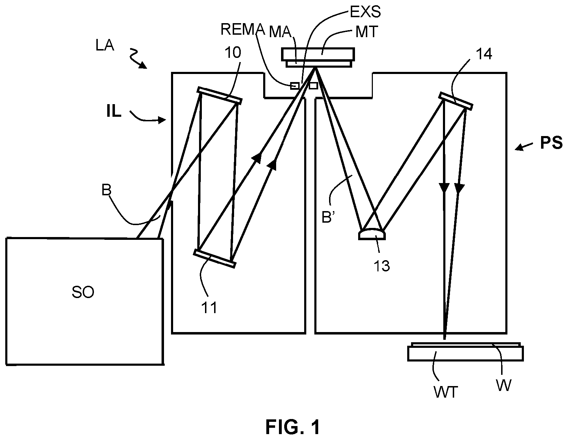

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g. six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO may be a laser produced plasma (LPP) source, a discharge produced plasma (DPP) source, a free electron laser (FEL) or any other radiation source that is capable of generating EUV radiation.

The lithographic apparatus LA of Figure 1 may be a scanner-type lithographic apparatus. In such scanner-type lithographic apparatus the illumination beam is guided through a masking device REMA to the patterning device MA. The masking device REMA comprises an exposure slit EXS through which the illumination beam propagates. The exposure slit EXS is may be curved or rectangular and mainly extends in a slit direction.

During projection of the patterned radiation beam on exposure fields on the substrate W, the patterning device MA is moved with a scanning movement in a scanning direction with respect to the exposure slit EXS. The scanning direction (y-direction) is perpendicular to the slit direction (x-direction). Simultaneously with the scanning movement of the patterning device MA, the substrate W is moved with a scanning movement with respect to the projection system PS such that the patterned radiation beam having a cross-section defined by the exposure slit EXS will be scanned along the substrate W to project the patterned radiation beam on the respective exposure field. The length of the exposure slit EXS , e.g. its dimension in slit direction, is adapted by the masking device REMA to the width of the exposure field on which the patterned radiation beam is projected. The width of the exposure slit EXS, i.e. its dimension in scanning direction, is substantially smaller than the length of the exposure field EXS. To fully cover the full exposure field the patterned radiation beam is scanned in scanning direction

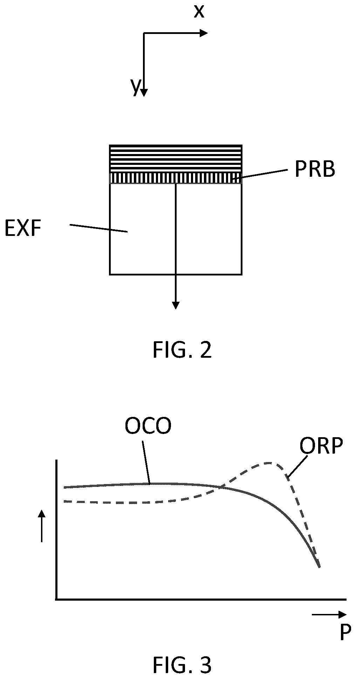

Figure 2 schematically depicts a cross-section of a patterned radiation beam PRB as dimensioned by the exposure slit EXS of the masking device REMA in a scanning movement with respect to an exposure field EXF. The shape of the cross-section of the patterned radiation beam substantially corresponds with the shape of the exposure slit EXS. The length of the cross-section of the patterned radiation beam PRB (in x-direction) as projected on the exposure field EXF is substantially the same as the width of the exposure field EXF. The width of the cross-section of the patterned radiation beam PRB (in y-direction) is smaller than the length of the exposure field EXF.

Figure 2 shows only one exposure field EXF. In practice, a substrate W may have a multitude of exposure fields, each exposure field being designed to be exposed to a pattern of a patterning device.

Deformation of a substrate W, in particular in-plane deformation may lead to overlay errors due to mis-alignment of the patterned radiation beam PRB with respect to the exposure field EXF. This deformation may for example be caused by clamping a warped substrate W on a substrate support WT. To reduce these overlay errors, a position of an aerial image of the patterned radiation beam projected on the exposure field may be adjusted in dependence of a deformation of the exposure field on which the patterned radiation beam is projected.

The position of this aerial image can be adjusted by adjusting positions of the patterning device and/or positions of reflective surfaces in the projection system PS of the lithographic apparatus. The flexibility to apply these corrections may be limited due to the hardware used. For example, the corrections provided by adjusting positions of the reflective surfaces in the projection system PS may be limited to second order corrections.

In the scanning direction, the width of the cross-section of the patterned radiation beam PRB is relatively small with respect to the exposure field EXF and the dimension of the exposure slit EXS in slit direction. The overlay errors in this scanning direction may therefore be relatively small compared to the overlay errors that may occur in the slit direction of the patterned radiation beam PRB. During the scanning movement of the exposure field EXF in the scanning direction, e.g. y-direction, with respect to the patterned radiation beam, the correction in scanning direction may be continuously adjusted to the part of the exposure field EXF that is aligned with the patterned radiation beam PRB.

The cross-section of the patterned radiation beam in slit direction, e.g. x-direction, extends over the complete width of the exposure field EXF. Due to this relatively large dimension in the slit direction, it may be more difficult to correct for overlay errors in this direction.

Figure 3 shows a graph with an overlay error related parameter ORP in relation to a position P of the exposure field EXF in the slit direction for a specific position of the patterned radiation beam PRB in the scanning direction, for example the position shown in Figure 2. The overlay error related parameter ORP may be determined by measurement of the substrate W and is typically related to deformation of the substrate W, such as in-plane deformation of the substrate W. Figure 3 also shows an overlay correction OCO to at least partially correct the overlay error related parameter ORP. The overlay correction OCO is a second order correction.

By comparison of the overlay error related parameter ORP and the overlay correction OCO, it can be concluded that the overlay error related parameter ORP and the overlay correction do not completely match. In other words a substantial error residue remains. As a result, the overlay error cannot be fully corrected. For some exposure fields EXF the error residue and associated overlay error may even be too large to be acceptable. These exposure fields EXF may be classified as non-correctable. This is generally undesirable.

The present disclosure proposes to split in the slit direction, e.g. x-direction, at least one of the multiple exposure fields in two or more partial exposure fields. The patterned radiation beam PRB may be projected on the two or more partial exposure fields in two or more separate scanning movements of the patterning device in the scanning direction. This may improve available overlay correction capacity for deformation of the substrate W, since for each scanning movement its own overlay correction may be applied.

In such approach, the cross-section of the patterned radiation beam has to be adapted to the width of the respective partial exposure field. This can be done by using the masking device REMA to mask the part of the radiation beam that should not be projected on the exposure field. The masking device REMA comprises masking blades that are arranged to delimit the length of the exposure slit in the slit direction. By movement of these masking blades in the slit direction the position and length of the exposure slit EXS in slit direction and therewith the position and length of the cross-section of the patterned radiation beam projected on the exposure field can be adjusted.

In an alternative embodiment a MEMS illuminator may be provided, which MEMS illuminator is arranged to provide the radiation beam only in that part of the exposure slit EXS associated with the respective one of the two or more partial exposure fields to be exposed.

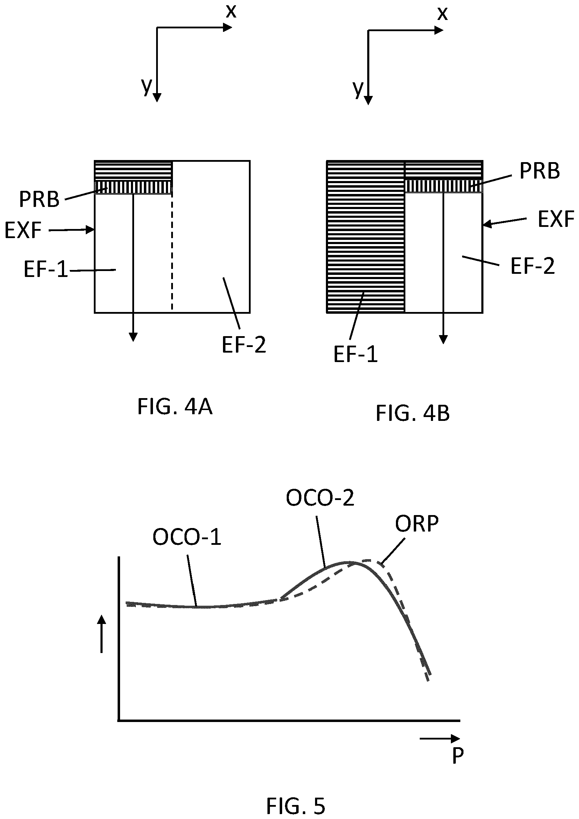

Figures 4A and 4B show an example of two separate scanning movements over two partial exposure fields. The exposure field EXF on the substrate W is split in slit direction in a first partial exposure field EF-1 and a second partial exposure field EF-2, i.e. each of the first partial exposure field EF-1 and the second partial exposure field EF-2 extend over a part of the width of the exposure field EXF in x-direction. Both the first partial exposure field EF-1 and the second partial exposure field EF-2 extend over the complete length of the exposure field EXF in the scanning direction.

Figure 4A shows a first scanning movement during which the patterned radiation beam PRB is projected on the first exposure field EF-1. The part of the exposure field EXF that has already been exposed to the patterned radiation beam PRB is indicated by a horizontally hatched area. The patterned radiation beam PRB is thus adapted to only project the patterned radiation beam on the first partial exposure field EF-1. The masking device REMA (see Fig. 1) is used to mask the part of the radiation beam that would be projected after being imparted with a pattern on the second partial exposure field EF-2.

Figure 4B shows a second scanning movement during which the patterned radiation beam PRB is projected on the second exposure field EF-2. The part of the exposure field EXF that has already been exposed to the patterned radiation beam PRB is indicated by a horizontally hatched area. It can be seen that the first partial exposure field EF-1 has already been completely exposed to the patterned beam of radiation PRB. In the second scanning movement, the patterned radiation beam PRB is thus adapted to only project the patterned radiation beam PRB on the second partial exposure field EF-2. The masking device REMA (see Fig. 1) is used in the second scanning movement to mask the part of the radiation beam that would be projected after being imparted with a pattern on the first partial exposure field EF-1.

Figure 5 shows a graph with an overlay error related parameter ORP in relation to a position P of the exposure field EXF in the slit direction for a specific position of the patterned radiation beam PRB in the scanning direction. As this overlay error related parameter ORP relates to the same position on the exposure field EXF in scanning direction as shown in Figure 3, the overlay error related parameter ORP of Figures 3 and 5 are the same.

As a result of splitting the exposure field EXF in slit direction in a first partial exposure field EF-1 and a second partial exposure field EF-2, the overlay correction can be determined for each scanning movement. This means that a first overlay correction OCO-1 can be determined to compensate the overlay error related parameter ORP in the first partial exposure field EF-1 and a second overlay correction OCO-2 can be determined to compensate the overlay error related parameter ORP in the second partial exposure field EF-2. Figure 5 shows the first overlay correction OCO-1 and the second overlay correction OCO-2. Both the first overlay correction OCO-1 and the second overlay correction OCO-2 are second order corrections. It can be seen that the difference between the overlay error related parameter ORP and the combination of the first overlay correction OCO-1 and the second overlay correction OCO-2 is substantially smaller than the difference between the overlay error related parameter ORP and the overlay correction OCO in Figure 3. The error residue is thus also substantially smaller resulting in a better overlay performance.

Similarly, the focus performance can be improved by splitting the exposure field EXF in slit direction in a first partial exposure field EF-1 and a second partial exposure field EF-2, and determining a focus correction for each respective scanning movement with respect to the first partial exposure field EF-1 and the second partial exposure field EF-2, respectively. This means that a first focus correction can be determined to compensate an focus error related parameter in the first partial exposure field EF-1 and a second focus correction can be determined to compensate a focus error related parameter in the second partial exposure field EF-2.

Although the split of the exposure field EXF in two or more partial exposure fields to be exposed in separate scanning movements has substantial advantage with respect to reducing focus and/or overlay errors, the required separate scanning movements negatively influence the throughput capacity of the lithographic process. Therefore, it may be desirable to apply the split of the exposure field EXF only at locations of the substrate W where the deformation of the substrate W, in particular in-plane deformation of the substrate W, is substantial enough to accept the loss of throughput. The selection criterion to determine whether an exposure field EXP should be split in two or more partial exposure fields for exposure during two or more separate scanning movements, or not, is for example a residual of a deformation of the substrate W after deformation correction.

The lithographic apparatus LA may be arranged, for example in a processing device, to select, based on a selection criterion, at least one of the multiple exposure fields to be split in the slit direction in two or more partial exposure fields, wherein the two or more partial exposure fields are exposed to the patterned radiation beam in two or more separate scanning movements of the patterning device. The exposure fields that do not fulfil the selection criterion may be exposed to the patterned radiation beam over the whole width of the respective exposure field in slit direction during a single scanning movement. The selection criterion may be based on an overlay and/or focus related parameter. The selection criterion is for example the error residue between the overlay error related parameter ORP and the overlay correction OCO as shown in Figure 3.

By using such selection criterion only the exposure fields having deformations that cannot be sufficiently compensated by second order corrections, may be split in multiple partial exposure fields. In this way, a proper balance between overlay and throughput performance can be obtained in the lithographic process.

Again referring to Fig. 4A and 4B, the location of the splitting line between the first partial exposure field EF-1 and the second partial exposure field EF-2 of Figure 4A and 4B does not have to be predetermined in the pattern of the patterning device. There may be continuous features of the pattern running between the partial exposure fields. It may not be required to create a pattern with subfields with a black border between them.

As discussed above, masking blades of the masking device REMA may be used to adapt the size of the patterned radiation beam PRB. The masking blades may however not provide a perfect separation between the first partial exposure field EF-1 and the second partial exposure field EF-2. In practice, the masking blades may create overlapping half-shadows around the splitting line between the first partial exposure field EF-1 and the second partial exposure field EF-2.

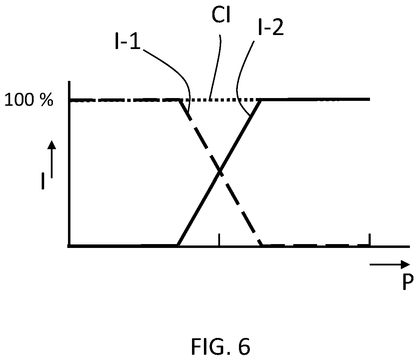

Figure 6 shows the radiation intensity I-1 of the first exposure during the first scanning movement and the radiation intensity I-2 of the second exposure during the second scanning movement in dependence of the position P in slit direction. It is desirable that the combined radiation intensity CI of the first exposure and the second exposure is about 100% over the whole width of the exposure field, i.e. equal to the desired radiation intensity.

When positioning the masking blades of the masking device during the two or more separate scanning movements, the half-shadows resulting from the masking blades should therefore be taken into account. The positions of the masking blades should be selected such that the combined radiation intensity CI received by the exposure field during the two or more scanning movements is substantially the same over the width of the exposure field in slit direction.

An advantage of the half-shadows resulting from the masking blade edges is that there is no strict separation between the first and second exposure. The half-shadows may provide a smooth transition between projected patterns of the first exposure and the second exposure, i.e. stitching. This smooth transition may be beneficial for continuous features of the pattern running between the partial exposure fields and take away the need to create a pattern with subfields with a black border between them at the location of the splitting line between the two partial exposure fields.

In the shown example of Figure 4, the exposure field EXF is split into a first partial exposure field EF-1 and a second partial exposure field EF-2 having an equal width in the slit direction, e.g. the x-direction. In other embodiments, the first partial exposure field EF-1 and the second partial exposure field EF-2 may not have an equal width. For example, the width of the first partial exposure field EF-1 and the second partial exposure field EF-2 may be selected such that the error residue in both the first partial exposure field EF-1 and the second partial exposure field EF-2 is the same or substantially the same over the length of the exposure field EXF. In the example of Figure 5, this could result in that the first partial exposure field EF-1 would have a larger width than the second partial exposure field EF-2 in order to obtain the same error residue in the first partial exposure field EF-1 and the second partial exposure field EF-2, assuming that the overlay error related parameter ORP will be substantially the same over the length of the exposure field EXF.

In other embodiments, in order to further increase the correction potential in slit direction, the exposure field may be split in three or more partial exposure fields having equal or different widths in slit direction, wherein for each of the three or more partial exposure fields a separate scanning movement is carried out to project the patterned radiation beam on the respective part of the exposure field.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A lithography projection method, comprising:
providing a radiation beam,
imparting the radiation beam with a pattern of a patterning device in its cross-section to form a patterned radiation beam,
projecting the patterned radiation beam on multiple exposure fields of a substrate,
wherein imparting the radiation beam with the pattern of the patterning device comprises moving the patterning device with a scanning movement in a scanning direction with respect to an exposure slit mainly extending in a slit direction perpendicular to the scanning direction,
wherein the lithography projection method further comprises:
splitting in the slit direction at least one of the multiple exposure fields in two or more partial exposure fields, and
projecting the patterned radiation beam on the two or more partial exposure fields in two or more separate scanning movements of the patterning device in the scanning direction.

2. The lithography projection method of claim 1, wherein for each of the two or more separate scanning movements, a position of an aerial image of the patterned radiation beam projected on the partial exposure field is adjusted in dependence of a deformation of the partial exposure field.

3. The lithography projection method of claim 1 or 2, wherein projecting the patterned radiation beam on one of the two or more partial exposure fields comprises masking the radiation beam for the other of the two or more partial exposure fields.

4. The lithography projection method of claim 3, wherein masking the radiation beam comprises adjusting a position of masking blades of a masking device to reduce a length of the exposure slit in the slit direction, in order to project the patterned radiation beam only on the respective one of the two or more partial exposure fields.

5. The lithography projection method of claim 4, wherein the position of the masking blades during the two or more separate scanning movements is selected such that after completing the two or more separate scanning movements a maximum radiation intensity received by the partial exposure fields is substantially the same over a width of the exposure field in slit direction.

6. The lithography projection method of claim 1 or 2, wherein the radiation beam is provided by a MEMS illuminator and wherein projecting the patterned radiation beam on one of the two or more partial exposure fields comprises providing the radiation beam only in a part of the exposure slit associated with the respective one of the two or more partial exposure fields.

7. The lithography projection method of any of the claim 1-6, wherein the method comprises selecting, based on a selection criterion, at least one of the multiple exposure fields to be split in the slit direction in two or more partial exposure fields, wherein the two or more partial exposure fields are to be projected with the patterned radiation beam in two or more separate scanning movements of the patterning device.

8. The lithography projection method of claim 7, wherein the patterned radiation beam is projected on the other of the multiple exposure fields during a single scanning movement over a whole width of the respective exposure field in slit direction.

9. The lithography projection method of claim 7 or 8, wherein the selection criterion is based on an overlay and/or focus related parameter.

10. The lithography projection method of any of the claims 1-9, wherein the method comprises measuring a deformation of each of the multiple exposure fields on the substrate, and determining for each exposure field, based on the measured deformation of the respective exposure fields, whether the patterned radiation beam is projected during a single scanning movement over a whole width of the respective exposure field in slit direction, or the patterned radiation beam is projected in two or more separate scanning movements of the patterning device, wherein each separate scanning movement is used to project the patterned radiation beam on one of two or more partial exposure fields of the exposure field in slit direction.

11. A lithographic apparatus, comprising:
a substrate table constructed to hold a substrate;
a projection system configured to project a radiation beam through an exposure slit area onto multiple exposure fields of the substrate; and
a patterning device configured to impart the radiation beam with a pattern in its cross-section to form a patterned radiation beam, wherein the patterning device is arranged to be moved with a scanning movement in a scanning direction with respect to the exposure slit, the exposure slit extending mainly in a slit direction perpendicular to the scanning direction; and
wherein the lithographic apparatus is arranged to:
split in the slit direction at least one of the multiple exposure fields in two or more partial exposure fields, and
project the patterned radiation beam on the two or more partial exposure fields in two or more separate scanning movements of the patterning device in the scanning direction.

12. The lithographic apparatus of claim 11, wherein the lithographic apparatus comprises a positioning system to position the substrate table, wherein for each of the two or more separate scanning movements, the positioning system is arranged to adjust a position of an aerial image of the patterned radiation beam projected on the exposure field in dependence of a deformation of the two or more partial exposure fields.

13. The lithographic apparatus of claim 11 or 12, wherein the lithographic apparatus comprises a masking device having masking blades, wherein the masking blades are configured to mask the radiation beam, wherein the masking device is arranged to adjust a position of the masking blades to reduce a length of the exposure slit in the slit direction, such that, when projecting the patterned radiation beam on one of the two or more partial exposure fields, the patterned radiation beam is only projected on the respective one of the two or more partial exposure fields.

14. The lithographic apparatus of claim 11 or 12, wherein the lithographic apparatus comprises a MEMS illuminator that is arranged to provide, when projecting the patterned radiation beam on one of the two or more partial exposure fields, the radiation beam only in a respective part of the exposure slit associated with the one of the two or more partial exposure fields.

15. The lithographic apparatus of any of the claims 11-14, wherein the lithographic apparatus comprises a measurement system that is arranged to measure a deformation of multiple exposure fields on the substrate, wherein the lithographic apparatus is configured to determine for each exposure field, based on the deformation of the respective exposure field, whether the patterned radiation beam is projected during a single scanning movement over a whole width of the respective exposure field in slit direction, or the patterned radiation beam is projected in two or more separate scanning movements of the patterning device, wherein each separate scanning movement is used to project the patterned radiation beam on one of two or more partial exposure fields of the exposure field in slit direction.
